# EUROPÄISCHE PATENTSCHRIFT

(11) **EP 1 918 649 B1**
(45) Veröffentlichungstag und Bekanntmachung des Hinweises auf die Patenterteilung: **18.07.2018**
(21) Anmeldenummer: 07020736.0
(22) Anmeldetag: 23.10.2007
(51) Int. Cl.: F24D 19/10, G01D 4/00, G01R 22/10, G05D 23/19, H02J 3/00

(54) **Heizungsanlage**
Heating system
Installation de chauffage

(30) Priorität: 26.10.2006 DE 102006050488
(43) Veröffentlichungstag der Anmeldung: 07.05.2008
(73) Patentinhaber: Robert Bosch GmbH, 70442 Stuttgart (DE)
(72) Erfinder: Schäfer, Frank, 35043 Marburg (DE)

(56) Entgegenhaltungen:
- DE-A1- 3 612 121
- DE-A1- 10 055 977
- GB-A- 1 158 316

## Beschreibung

Die Erfindung betrifft eine Heizungsanlage mit mindestens einem Regelgerät nach dem Oberbegriff des Patentanspruches 1.

Eine gattungsgemäße Heizungsanlage besitzt mindestens ein Regelgerät zum Steuern und Regeln des Betriebes. Dies betrifft in der Regel fast alle Komponenten eines Heizungssystems. Dazu gehören beispielsweise das Regelgerät selbst, Brenner, Gebläse, Vorwärmungseinrichtungen, Fembedienungseinrichtungen, Heizkreis-, Solar-, Speicherlade- und Zirkulationspumpen sowie diverse Stellglieder. Sowohl das Regelgerät selbst als auch die Komponenten umfassen elektrotechnische Bauteile, weiche elektrische Energie verbrauchen. Alle aktiven elektrotechnischen Komponenten sind an die Regeleinrichtung angeschlossen, jeweils an einen zugeordneten Eingang an einem Mikroprozessor. An Regelgeräten von Heizungsanlagen, aber auch an Komponenten sind Betriebsstundenzähler bekannt

Die Bewertung des elektrischen Energieverbrauchs einer Heizungsanlage bekommt zunehmend Bedeutung, sowohl bei Kauf- und Auswahlentscheidungen von Heizungssystemen als auch für Abrechnungszwecke bei den Betreibern der Heizungsanlagen. DE 36 12 121 A1 offenbart eine Heizungsanlage gemäß des Oberbegriffs des Anspruchs 1. Von der D1 erhält der Fachmann die Anregung, intelligente Sensoren zur Erfassung des Verbrauchs des Strom-, Gas-, Wasser-, Heizwärme- und dergleichen an den Zähler der Endverbraucher anzuordnen, diese zu verbinden, Möglichkeiten zur Eingabe bestimmter Verbraucherkosten vorzusehen und eine Verbrauchs-Kosten-Erfassung sowie ein Kontrollsystem zu schaffen, das Verbraucher und Versorgungsunternehmen über einen bidirektionale Datentransfer unmittelbar miteinander koppeln. Auf diese Weise können dann separat Brennstoffverbrauch, Stromverbrauch, Wasserverbrauch usw. erfasst und angezeigt werden. Hier ist es jedoch nicht möglich, die Effizienz der Heizungsanlage als solches mit ihren Komponenten zu bestimmen. Das ist auch gar nicht Thema der D1 und sie gibt auch keine Anregung dazu. Der Erfindung liegt daher die Aufgabe zu Grunde, eine Möglichkeit zur Auswertung des elektrischen Energieverbrauchs einer Heizungsanlage zu schaffen.

Erfindungsgemäß wurde dies mit den Merkmalen des Patentanspruches 1 gelöst. Vorteilhafte Weiterbildungen sind den Unteransprüchen zu entnehmen.

Im Regelgerät sind Werte für die Leistungsaufnahme von elektrotechnischen Bauteilen des Regelgerätes und/oder von elektrotechnischen Bauteilen in Komponenten hinterlegt, und/oder einzugeben. Mindestens ein Betriebsstundenzähler wird ausgewertet, und der aktuelle elektrische Energieverbrauch und/oder der elektrische Energieverbrauch in einem vergangenen Zeitraum wird ermittelt und angezeigt. Die Laufzeiten liegen im Regelgerät oder in den einzelnen Komponenten gemäß dem Stand der Technik schon vor. In einer bevorzugten Ausführungsform werden dann der aktuelle elektrische Energieverbrauch und/oder der elektrische Energieverbrauch in einem vergangenen Zeitraum ins Verhältnis zum Brennstoff-Energieverbrauch gesetzt und angezeigt

Die aktuellen Stromkosten sind anhand eines Wertes für eine elektrische Energieverbrauchseinheit im Regelgerät einzugeben. Dazu wird der aktuelle elektrische Energieverbrauch und/oder der elektrische Energieverbrauch in einem vergangenen Zeitraum ermittelt, und danach werden die elektrischen Energiekosten für den aktuellen Zeitpunkt und/oder einen vergangenen Zeitraum ermittelt und angezeigt.

Vorzugsweise sind Werte für die Leistungsaufnahme von elektrotechnischen Bauteilen über ein Menü, insbesondere eine Tabelle, an der Anzeigevorrichtung des Regelgerätes einzugeben. Dies sind mittlere und bauteiltypische Leistungsangaben in Watt, welche bereits vom Hersteller aus hinterlegt sind und dann bei der Installation der Heizungsanlage mit dem Aktivieren von Komponenten im Regelgerät aktiviert werden. Die ermittelten Werte für den elektrischen Energieverbrauch, für deren Verhältnis zum Brennstoff-Energieverbrauch und für die elektrischen Energiekosten werden über ein Menü, insbesondere eine Tabelle, an der Anzeigevorrichtung des Regelgerätes angezeigt

Ein Zeitintervall für den vergangenen Zeitraum, für den Werte ermittelt werden sollen, ist bereits voreingestellt und dann bei der Installation der Heizungsanlage beliebig veränderbar. Vorzugsweise ist das Zeitintervall für den vergangenen Zeitraum, für den Werte ermittelt werden sollen, über einen Starttag und einen Endtag einzugeben. Dadurch erhält der Nutzer der Heizungsanlage die Energieverbrauchswerte genau für seinen Wunschzeitraum, für den er die Information benötigt. Auch können mehrere Zeitabschnitte, zum Beispiel Monate und Quartale abgefragt werden, weil im Regelgerät ein beliebiges Aufaddieren im Rückblick möglich ist.

Mit der Erfindung wird eine einfache Möglichkeit zur Auswertung des elektrischen Energieverbrauchs einer Heizungsanlage geschaffen, welche den Nutzeranforderungen, einerseits für die laufende Überwachung von Heizungssystemen und andererseits auch für Abrechnungszwecke der Betreiber, gerecht wird. Die Genauigkeit wird nicht so hoch sein wie bei einer Verwendung von Stromzählern, aber diese Variante scheidet aus wirtschaftlichen Gründen aus, auch weil die Komponenten einer Heizungsanlage oft an verschiedenen Stromkreisen angeschlossen sind. Beispielsweise lassen sich Stromkosten für Stromkostenabrechnungen einfacher abschätzen. Besonders bei vermieteten Wohneinheiten, welche ursprünglich nicht für das Vermieten ausgelegt sind, trifft dies soft zu.

## Patentansprüche

1. Heizungsanlage umfassend Komponenten wie Brenner, Gebläse, Vorwärmungseinrichtungen, Fernbedienungseinrichtungen, Heizkreis-, Solar-, Speicherlade- und Zirkulationspumpen sowie diverse Stellglieder, sowie mit mindestens einem, elektrische Energie verbrauchende elektrotechnische Bauteile einschließenden Regelgerät, sowie mit weiteren, elektrische Energie verbrauchenden, elektrotechnischen Bauteilen an Komponenten der Heizanlage, welche an das Regelgerät angeschlossen sind, wobei mindestens ein Betriebsstundenzähler im Regelgerät vorgesehen ist,
**dadurch gekennzeichnet, dass** im Regelgerät Werte für die Leistungsaufnahme von elektrotechnischen Bauteilen des Regelgerätes und/oder von elektrotechnischen Bauteilen in Komponenten hinterlegt und/oder einzugeben sind, dass mindestens ein Betriebsstundenzähler ausgewertet wird, und dass der aktuelle elektrische Energieverbrauch und/oder der elektrische Energieverbrauch in einem vergangenen Zeitraum ermittelt und angezeigt wird.

2. Heizungsanlage nach Anspruch 1,
**dadurch gekennzeichnet, dass** der aktuelle elektrische Energieverbrauch und/oder der elektrische Energieverbrauch in einem vergangenen Zeitraum ins Verhältnis zum Brennstoff-Energieverbrauch gesetzt und angezeigt werden.

3. Heizungsanlage nach Anspruch 1 oder 2,
**dadurch gekennzeichnet, dass** die Stromkosten anhand eines Wertes für eine elektrische Energieverbrauchseinheit im Regelgerät einzugeben sind, dass der aktuelle elektrische Energieverbrauch und/oder der elektrische Energieverbrauch in einem vergangenen Zeitraum ermittelt wird, und dass die elektrischen Energiekosten für den aktuellen Zeitpunkt und/oder einen vergangenen Zeitraum ermittelt und angezeigt werden.

4. Heizungsanlage nach einem der Ansprüche 1 bis 3,
**dadurch gekennzeichnet, dass** Werte für die Leistungsaufnahme von elektrotechnischen Bauteilen über ein Menü, insbesondere eine Tabelle, an der Anzeigevorrichtung des Regelgerätes einzugeben sind.

5. Heizungsanlage nach einem der Ansprüche 1 bis 4,
**dadurch gekennzeichnet, dass** Werte für die Leistungsaufnahme von elektrotechnischen Bauteilen in Form von mittleren und bauteiltypischen Leistungsangaben in Watt hinterlegt sind und mit dem Aktivieren von Komponenten bei der Installation aktiviert werden.

6. Heizungsanlage nach einem der Ansprüche 1 bis 5,
**dadurch gekennzeichnet, dass** Werte für den elektrischen Energieverbrauch, für deren Verhältnis zum Brennstoff-Energieverbrauch und für die elektrischen Energiekosten über ein Menü, insbesondere eine Tabelle, an der Anzeigevorrichtung des Regelgerätes angezeigt werden

7. Heizungsanlage nach einem der Ansprüche 1 bis 6,
**dadurch gekennzeichnet, dass** ein Zeitintervall für den vergangenen Zeitraum, für den Werte ermittelt werden sollen, voreingestellt und veränderbar ist.

8. Heizungsanlage nach dem Anspruch 7, **dadurch gekennzeichnet, dass** das Zeitintervall für den vergangenen Zeitraum, für den Werte ermittelt werden sollen, über einen Starttag und einen Endtag des Zeitintervalles einzugeben ist.

## Claims

1. Heating system comprising components such as burner, fan, preheating devices, remote-control devices, heating-circuit, solar, tank-loading and circulation pumps and diverse actuators, having at least one control device including electrotechnical assemblies consuming electrical energy, and having further electrotechnical assemblies consuming electrical energy on components of the heating system, which are connected to the control device, at least one running time meter being provided in the control device,
**characterized in that** values for the power consumption of electrotechnical assemblies of the control device and/or of electrotechnical assemblies in components are stored and/or to be entered in the control device, **in that** at least one running time meter is evaluated, and **in that** the current electrical energy consumption and/or the electrical energy consumption in a preceding time period is/are determined and displayed.

2. Heating system according to Claim 1,
**characterized in that** the current electrical energy consumption and/or the electrical energy consumption in a preceding time period is/are placed in a ratio with the fuel energy consumption and displayed.

3. Heating system according to Claim 1 or 2,
**characterized in that** the power costs are to be entered into the control device by using a value for an electrical energy consumption unit, **in that** the current electrical energy consumption and/or the electrical energy consumption in a preceding time period is/are determined, and **in that** the electrical energy costs for the current time and/or a preceding time period are determined and displayed.

4. Heating system according to one of Claims 1 to 3,
**characterized in that** values for the power consumption of electrotechnical assemblies are to be entered via a menu, in particular a table, on the display device of the control device.

5. Heating system according to one of Claims 1 to 4,
**characterized in that** values for the power consumption of electrotechnical assemblies are stored in the form of average and component-typical power information in watts and activated with the activation of components during the installation.

6. Heating system according to one of Claims 1 to 5,
**characterized in that** values for the electrical energy consumption, for the ratio of the same to the fuel energy consumption and for the electrical energy costs are displayed via a menu, in particular a table, on the display device of the control device.

7. Heating system according to one of Claims 1 to 6,
**characterized in that** a time interval for the preceding time period for which values are to be determined is preset and can be varied.

8. Heating system according to Claim 7,
**characterized in that** the time interval for the preceding time period for which values are to be determined is to be entered via a start day and an end day of the time interval.

## Revendications

1. Installation de chauffage comprenant des composants tels que des brûleurs, des soufflantes, des dispositifs de préchauffage, des dispositifs de commande à distance, des pompes de circuit de chauffage, solaires, de charge à accumulation et de circulation et divers actionneurs, ainsi qu'au moins un appareil de régulation comprenant des composants électrotechniques consommateurs d'énergie électrique, et d'autres composants électrotechniques consommateurs d'énergie électrique disposés sur des composants de l'installation de chauffage, qui sont reliés à l'appareil de régulation, dans laquelle il est prévu au moins un compteur horaire de fonctionnement dans l'appareil de régulation,
**caractérisée en ce que** des valeurs de la consommation d'énergie des composants électrotechniques de l'appareil de régulation et/ou de composants électrotechniques sont stockées et/ou introduites dans des composants de l'appareil de régulation, **en ce qu'**au moins un compteur horaire de fonctionnement est analysé et **en ce que** la consommation d'énergie électrique instantanée et/ou la consommation d'énergie électrique au cours d'une période antérieure est déterminée et affichée.

2. Installation de chauffage selon la revendication 1,
**caractérisée en ce que** la consommation d'énergie électrique instantanée et/ou la consommation d'énergie électrique au cours d'une période antérieure sont réglées et affichées par rapport à la consommation d'énergie combustible.

3. Installation de chauffage selon la revendication 1 ou 2,
**caractérisée en ce que** les coûts en électricité doivent être introduits dans l'appareil de régulation sur la base d'une valeur d'une unité de consommation d'énergie électrique, **en ce que** la consommation d'énergie électrique instantanée et/ou la consommation d'énergie électrique au cours d'une période antérieure est déterminée et **en ce que** les coûts en énergie électrique sont déterminés et affichés pour l'instant présent et/ou pour une période antérieure.

4. Installation de chauffage selon l'une des revendications 1 à 3,
**caractérisée en ce que** les valeurs de la consommation d'énergie des composants électrotechniques doivent être introduites par l'intermédiaire d'un menu, en particulier d'un tableau, sur le dispositif d'affichage de l'appareil de régulation.

5. Installation de chauffage selon l'une des revendications 1 à 4,
**caractérisée en ce que** des valeurs de la consommation d'énergie de composants électrotechniques sont stockées en watts sous la forme de spécifications de puissance moyenne et de puissance typique des composants et sont activées pendant l'installation lors de l'activation des composants.

6. Installation de chauffage selon l'une des revendications 1 à 5,
**caractérisée en ce que** des valeurs de la consommation d'énergie électrique, de son rapport à la consommation d'énergie combustible et des coûts en énergie électrique sont affichées sur l'écran de l'appareil de régulation par l'intermédiaire d'un menu, en particulier d'un tableau.

7. Installation de chauffage selon l'une des revendications 1 à 6,
**caractérisée en ce qu'**un intervalle de temps correspondant à la période antérieure pendant laquelle des valeurs doivent être déterminées peut être prédéfini et modifié.

8. Installation de chauffage selon la revendication 7,
**caractérisée en ce que** l'intervalle de temps correspondant à la période antérieure pendant laquelle des valeurs doivent être déterminées doit être introduit par l'intermédiaire d'un jour de début et d'un jour de fin de l'intervalle de temps.
